# EUROPEAN PATENT SPECIFICATION

(11) **EP 3 670 043 B1**
(45) Date of publication and mention of the grant of the patent: **24.07.2024**
(21) Application number: 17921877.1
(22) Date of filing: 30.11.2017
(51) Int. Cl.: C23C 14/06, C23C 30/00, C23C 14/02, C23C 14/34, C23C 14/00

(54) **COATED CUTTING TOOL**
BESCHICHTETES SCHNEIDWERKZEUG
OUTIL DE COUPE REVÊTU

(30) Priority: 15.08.2017 JP 2017156730
(43) Date of publication of application: 24.06.2020
(73) Proprietor: MOLDINO Tool Engineering, Ltd., Tokyo 130-0026 (JP)
(72) Inventor: SASAKI, Tomoya, Yasu-shi, Shiga 520-2323 (JP)
(74) Representative: Hoffmann Eitle
(86) International application number: PCT/JP2017/043027
(87) International publication number: WO 2019/035219

(56) References cited:
- WO-A1-2014/142190
- WO-A1-2015/186413
- WO-A1-2017/170536
- JP-A- 2005 344 148
- JP-A- 2008 545 063
- JP-A- 2011 189 419
- US-A1- 2015 050 489
- US-A1- 2015 050 490
- US-A1- 2015 292 078

## Description

### [Technical Field]

The present invention relates to a coated cutting tool having a hard coating film on a surface of a base material.

Priority is claimed on Japanese Patent Application No. 2017-156730, filed August 15, 2017.

### [Background Art]

A nitride coating film (which will hereinafter be referred to as AlTiN) of Al and Ti is a film of a type having excellent wear resistance and heat resistance and is applied widely to coated cutting tools. Generally, it is known that when the amount of Al in AlTiN increases, the amount of AlN with a hexagonal closest packing structure (which will sometimes be referred to as an hcp structure) increases and a coating film hardness deteriorates. For example, Patent Document 1 discloses AlTiN in which the amount of Al is changed, describing that the coating film hardness deteriorates causing deterioration in tool performance with AlTiN having an hcp structure with a significant amount of Al.

On the other hand, recently, in order to improve lubricity or welding resistance, it has also been proposed that a hard coating film containing AlN having an hcp structure with a significant amount of Al be provided in the outermost layer of a coated cutting tool. For example, Patent Document 2 discloses a coated cutting tool in which a hard coating film containing Cr in a base of AlTiN having a wurtzite-type crystal structure (hcp structure) is provided in an upper layer of a nitride laminated coating film.

Incidentally, an arc ion plating method, which is one of physical vapor deposition methods, is applied to the specific examples of Patent Document 1 and Patent Document 2. Since residual compressive stress is applied to a hard coating film to enhance defect resistance in a physical vapor deposition method, the method is mainly applied to coated cutting tools which are subjected to milling working. Since a high ionization rate of a target and excellent adhesion with respect to a base material are exhibited in the arc ion plating method of the physical vapor deposition methods, the method is utilized widely. In the arc ion plating method, coating is performed by vaporizing a target component through an arc discharge. Therefore, a hard coating film unavoidably contains many droplets of several micrometers. On the other hand, in a sputtering method of physical vapor deposition methods, in which coating is performed by sputtering a target component with argon gas, droplets are unlikely to be generated. Therefore, a smooth hard coating film can be obtained. However, since a lower ionization rate of a target is exhibited in the sputtering method compared to the arc ion plating method, voids are easily formed inside a hard coating film and adhesion with respect to a base material is also poor. Therefore, generally, a hard coating film coated by the sputtering method tends to have deteriorated durability compared to a hard coating film coated by the arc ion plating method.

Recently, a high-output sputtering method in which power applied to targets as in Patent Document 3 and Patent Document 4 is instantaneously increased has begun to be applied.

### [Citation List]

### [Patent Literature]

[Patent Document 1]
   Japanese Unexamined Patent Application, First Publication No. H8-209333
[Patent Document 2]
   PCT International Publication No. WO2014/002948
[Patent Document 3]
   Japanese Unexamined Patent Application, First Publication No. 2011-189419
[Patent Document 4]
   Japanese Unexamined Patent Application, First Publication No. 2013-202700

Patent documents US 2015/050490 A1, US 2015/050489 A1 and US 2015/292078 A1 disclose other AlTiN coatings for cutting tools with good wear resistance and durability.

### [Summary of Invention]

### [Technical Problem]

According to the investigation of the inventor, it has become clear that when a nitride having an hcp structure composed of Al and Ti as main constituents with a significant amount of Al is coated by an arc ion plating method, sudden defects occur or a wear area increases in cutting working of quenched steel or the like, and therefore there is room for improvement in the life span of tool.

In consideration of the foregoing circumstances, an object of the present invention is to provide a coated cutting tool in which durability of an hcp-structured nitride composed of Al and Ti as main constituents is enhanced and which has excellent durability.

### [Solution to Problem]

According to the present invention, there is provided a coated cutting tool having a hard coating film on a surface of the tool as defined in claim 1. The hard coating film is a nitride containing aluminum (Al) within a range of 80 at% to 90 at% and containing titanium (Ti) within a range of 10 at% to 20 at% with respect to a total amount of metallic (including metalloid) elements, and containing argon (Ar) of 0.10 at% or more and 0.50 at% or less with respect to a total amount of the metallic elements (including metalloid) and nonmetallic elements. In the hard coating film, a crystal structure identified through X-ray diffraction is a hexagonal closed packing structure and a diffraction peak due to an AlN (100) plane indicates a maximum intensity. An average crystal grain size is within a range of 5 nm to 50 nm. In a cross-sectional observation of the hard coating film, there are five or fewer droplets having an equivalent circle diameter of 1.0 µm or larger per 100 µm².

It is preferable that in the hard coating film, when an amount of the metallic (including metalloid) elements, nitrogen, oxygen, carbon, and argon is 100 at%, an amount of the nitrogen be 50 at% or greater.

It is preferable that the hard coating film be provided in an outermost layer of the tool which comes into contact with a workpiece.

### [Advantageous Effects of Invention]

According to the present invention, it is possible to enhance durability of a coated cutting tool coated with an hcp-structured nitride composed of Al and Ti as main constituents.

### [Brief Description of Drawings]

Fig. 1 is a cross-sectional observation photograph of Example 1 taken with an electron microscope.
Fig. 2 is a view showing an X-ray diffraction pattern of the present Example 2.

### [Description of Embodiment]

The inventor has found that when defects included inside a coating film are reduced regarding a nitride of Al and Ti containing AlN having a hexagonal closest packing structure (hep structure) with a significant amount of Al, durability of a coated cutting tool tends to be improved even if a coating film hardness has deteriorated. Furthermore, it has been found that a coated cutting tool has excellent durability when a coating film structure is refined, droplets included in a hard coating film and gas components other than nitrogen are reduced, and a peak intensity due to an AlN (100) plane becomes the maximum regarding a nitride having an hcp structure containing Al and Ti with a significant amount of Al. Hereinafter, an embodiment of the present invention will be described in detail.

A cutting tool of the present embodiment is a coated cutting tool having a hard coating film including a nitride of Al and Ti on a surface of the tool. The coated cutting tool of the present embodiment can be used in a form of a ball end mill, a square end mill, a radius end mill, a multi-blade end mill, an insert, a drill, a cutter, a brooch, a reamer, a hob, a router, or the like.

For example, the coated cutting tool of the present embodiment can be used for cutting working of high-hardness steel, stainless steel, heat resistant steel, cast steel, or carbon steel. Details will be described in examples in the following parts. However, the coated cutting tool of the present embodiment particularly exhibits excellent durability in cutting working of quenched steel of which the hardness (HRC) is increased to 40 or higher through quenching.

### <Component composition: aluminum (Al) and titanium (Ti)>

The hard coating film according to the present embodiment is a nitride containing aluminum (Al) within a range of 80 at% to 90 at% and containing titanium (Ti) within a range of 10 at% to 20 at% with respect to a total amount of metallic (including metalloid) elements. A nitride composed of Al and Ti as main constituents forms a film of a type having an excellent balance between wear resistance and heat resistance and also has excellent adhesion with respect to a base material. The heat resistance of a hard coating film is further improved by particularly increasing the amount of Al. Particularly, when the amount of Al is increased, a protective oxide coating film is easily formed on a tool surface and the coating film structure becomes fine. Therefore, wear of a hard coating film due to welding is curbed easily.

In order for the foregoing effects when adding Al to be exhibited sufficiently, in the hard coating film according to the present embodiment, when all the metallic (including metalloid, the same applies hereinafter) elements make 100 at%, Al is set to 80 at% or more. On the other hand, if the amount of Al is increased excessively, the crystal structure of a hard coating film changes and becomes fragile. Therefore, in the hard coating film according to the present embodiment, when all the metallic elements make 100 at%, Al is set to 90 at% or less.

In the hard coating film according to the present embodiment, when all the metallic elements make 100 at%, Ti is set to 10 at% or more. Accordingly, excellent wear resistance can be applied to a hard coating film. On the other hand, if the amount of Ti contained in a hard coating film is increased excessively, it is difficult to obtain the foregoing effects when the amount of Al is increased. Therefore, in the hard coating film according to the present embodiment, when all the metallic elements make 100 at%, Ti is set to 20 at% or less.

In order to apply more excellent durability to a coated cutting tool, in the hard coating film according to the present embodiment, when all the metallic elements make 100 at%, it is preferable that the total amount of Al and Ti be set to 95 at% or greater. In addition, the hard coating film according to the present embodiment may be a nitride of Al and Ti.

The amount of metallic elements in the hard coating film according to the present embodiment can be measured using an electron probe microanalyzer (EPMA) regarding a hard coating film subjected to specular working. In this case, for example, the amount of metallic elements can be obtained after specular working of a hard coating film surface from an average obtained by analysis at five points using areas having a diameter of approximately 1 µm.

### <Crystal structure>

In the hard coating film according to the present embodiment, a crystal structure identified through X-ray diffraction is a hexagonal closest packing structure (hep structure). That is, the hard coating film according to the present invention is constituted of a single phase with an hcp structure, in which the peak intensity of a rock salt-type crystal structure (fee structure) is not substantially confirmed through X-ray diffraction. In addition, in the hard coating film according to the present invention, a diffraction peak due to the AlN (100) plane in the hcp structure indicates the maximum intensity. When a different diffraction peak indicates the maximum intensity, the hard coating film becomes fragile, and durability of the coated cutting tool tends to deteriorate. In an embodiment of the present invention, the intensity of the diffraction peak due to an AlN (101) plane becomes high subsequently to the intensity of the diffraction peak due to the AlN (100) plane. In an embodiment not covered by the present invention, the hard coating film according to the present embodiment may partially include an fcc structure in microanalysis using a transmission electron microscope (TEM).

### <Average crystal grain size>

In the hard coating film according to the present invention, the average crystal grain size of the hard coating film is within a range of 5 nm to 50 nm. If the microstructure of the hard coating film is excessively fine, the structure of the hard coating film becomes close to an amorphous structure. Therefore, toughness deteriorates extremely. In order to enhance crystallinity of a hard coating film and to reduce the amount of a fragile amorphous phase, the average crystal grain size of the hard coating film is set to 5 nm or larger. More preferably, the average crystal grain size of the hard coating film is set to 10 nm or larger. In addition, if the microstructure of the hard coating film becomes excessively coarse, toughness deteriorates and the fracture unit of the hard coating film increases. Therefore, damage to the tool increases. In order to curb damage to the tool by enhancing the toughness of the hard coating film and reducing the fracture unit, the average crystal grain size of the hard coating film is set to 50 nm or smaller. The average crystal grain size of the hard coating film is more preferably set to 40 nm or smaller. Still more preferably, the average crystal grain size of the hard coating film is set to 30 nm or smaller. The average crystal grain size of the hard coating film according to the present invention is measured from the half width of the diffraction peak due to the AlN (100) plane indicating the maximum intensity through X-ray diffraction.

### <Droplets>

In the hard coating film according to the present invention, there are five or fewer droplets having an equivalent circle diameter of 1 µm or larger per 100 µm² in a cross-sectional observation. In the present embodiment, after the coating film structure is refined in order to further enhance the toughness of the hard coating film, the number of physical defects included in the hard coating film is reduced. In a hard coating film coated by a physical vapor deposition method, droplets may become the main physical defect. In particular, since coarse droplets having an equivalent circle diameter of 1 µm or larger may become origins of fracture inside a hard coating film, the toughness of the hard coating film can be enhanced by reducing a generation frequency thereof. In the present invention, in order to enhance toughness of an hcp-structured nitride composed of Al and Ti as main constituents, in a cross-sectional observation of the hard coating film, there are five or fewer droplets having an equivalent circle diameter of 1 µm or larger per 100 µm². More preferably, there are three or fewer droplets per 100 µm². Still more preferably, there are one or fewer droplets per 100 µm². In addition, it is preferable that droplets having an equivalent circle diameter of 3 µm or larger be not included. More preferably, it is preferable that droplets having an equivalent circle diameter of 2 µm or larger be not included.

In addition, regarding a surface of the hard coating film as well, it is preferable that there be five or fewer droplets having an equivalent circle diameter of 1 µm or larger per 100 µm². More preferably, there are three or fewer droplets per 100 µm² on the surface of the hard coating film. Still more preferably, there are one or fewer droplets per 100 µm² on the surface of the hard coating film.

In order to evaluate droplets in a cross-sectional observation of the hard coating film, after being subjected to specular working, the hard coating film is worked by a converged ion beam method, a plurality of fields of view on the surface subjected to specular working are observed using a transmission electron microscope at 5,000 to 10,000 magnification. In addition, the number of droplets on the surface of the hard coating film can be obtained by observing the surface of the hard coating film using a scanning electron microscope (SEM) or the like.

### <Argon (Ar) content>

The hard coating film according to the present invention contains argon (Ar) of 0.5 at% or less with respect to the total amount of metallic elements and nonmetallic elements.

The generation frequency of droplets which may become defects in a hard coating film can be reduced by applying a sputtering method. On the other hand, in the sputtering method, since a target component is subjected to sputtering using argon ions, a hard coating film coated by the sputtering method contains a small amount of argon. In particular, argon is likely to be concentrated at crystal grain boundaries, when the crystal grain size becomes those of granules, the amount of argon tends to increase. However, when the amount of argon is increased, the bonding force between grains deteriorates at crystal grain boundaries. As in the hard coating film according to the present embodiment, in an hcp-structured nitride composed of Al and Ti as main constituents, since excessively included argon may become a defect, it is effective that the content thereof is set to a certain level or lower. Specifically, the hard coating film according to the present invention contains argon of 0.50 at% or less with respect to the total amount of the metallic elements and the nonmetallic elements. More preferably, the hard coating film of the present embodiment contains argon of 0.40 at% or less. Still more preferably, the hard coating film of the present embodiment contains argon of 0.30 at% or less.

In the sputtering method, when it is intended that the amount of argon included in a hard coating film be made as close as possible to 0 at%, the flow rate of argon becomes excessively small and sputtering becomes unstable. In addition, even if the amount of argon is approximated to 0 at%, basic characteristics such as toughness, heat resistance, and wear resistance as a hard coating film to be applied to a cutting tool may be impaired. However, in order to stabilize the sputtering method and to ensure basic coating film characteristics as a hard coating film to be applied to a cutting tool, it is necessary that argon of 0.10 at% or more be contained. More preferably, argon of 0.15 at% or more is contained in the hard coating film.

Similar to the foregoing measurement of the amount of the metallic elements, the amount of argon in the hard coating film according to the present embodiment can be measured using an electron probe microanalyzer (EPMA) regarding a hard coating film subjected to specular working. Similar to the foregoing measurement of the amount of the metallic elements, it can be obtained after specular working from an average obtained by analysis at five points using areas having a diameter of approximately 1 µm.

In addition to nitrogen, the hard coating film according to the present embodiment may include very small amounts of argon, oxygen, and carbon as nonmetallic elements. The amount of argon in a hard coating film can be obtained while the amount of the metallic (including metalloid) elements, nitrogen, oxygen, carbon, and argon is 100 at%. In addition, in the hard coating film according to the present embodiment, when the amount of the metallic (including metalloid) elements, nitrogen, oxygen, carbon, and argon is 100 at%, it is preferable that the amount of nitrogen be 50 at% or greater. Accordingly, nitrides are sufficiently formed in the hard coating film and durability tends to be excellent. However, if the amount of nitrogen is increased excessively, the hard coating film is likely to cause self-destruction. Therefore, it is preferable that the amount of nitrogen be 52% or lower. In evaluation, a value after the decimal point may be rounded down.

### <Metallic elements other than aluminum (Al) and titanium (Ti)>

The hard coating film according to the present embodiment may contain metallic elements other than Al and Ti. For example, for the purpose of improving wear resistance, heat resistance, and the like, the hard coating film according to the present embodiment can contain elements of Group 4a, Group 5a, and Group 6a in the periodic table and one or more elements selected from Si, B, and Y. These elements are generally contained in order to improve coating film characteristics of a hard coating film and can be added within a range in which durability of a coated cutting tool does not deteriorate extremely.

### <Component composition: oxygen (O) and carbon (C)>

Although the hard coating film according to the present embodiment is a nitride, it may contain very small amounts of oxygen and carbon in addition to argon described above. Since these elements form a very small amount of oxides or carbides in a nitride, the toughness of a hard coating film may deteriorate. If the amounts of oxygen and carbon unavoidably contained in a hard coating film can be reduced in the film thickness direction, toughness of a nitride having an hcp structure composed of Al and Ti as main constituents can be enhanced. In the hard coating film according to the present embodiment, more oxygen than carbon tends to be present as unavoidable impurities.

In the hard coating film according to the present embodiment, in order to reduce a minute amount of oxides contained in the hard coating film as much as possible, it is preferable that the amount of oxygen be set to 5.0 at% or lower in the film thickness direction. More preferably, the amount of oxygen is set to 4.0 at% or lower. In addition, in order to reduce a minute amount of carbides contained in the hard coating film as much as possible, it is preferable that the amount of carbon be set to 3.0 at% or lower in the film thickness direction. More preferably, the amount of carbon is set to 1.5 at% or lower.

The contents of oxygen and carbon in the film thickness direction can be obtained using a scanning X-ray photoelectron spectroscope device. Furthermore, the amounts of oxygen and carbon may be obtained while the amount of the total amount of carbon, nitrogen, oxygen, and the metallic (including metalloid) elements is 100 at%. Since large amounts of oxygen and carbon which have adhered from the atmosphere as unavoidable impurities are detected on the outermost surface of a hard coating film, analysis is performed from a position at a depth of 50 nm from the coating film surface in the film thickness direction.

In addition, when sputtering is performed using a mixed gas containing other rare gases in addition to argon, the hard coating film according to the present embodiment may also contain rare gases in addition to argon.

In the coated cutting tool of the present embodiment, in order to further improve adhesion of a hard coating film, as necessary, an intermediate layer may be provided separately between the base material of the tool and the hard coating film. For example, a layer composed of any one of a metal, a nitride, a carbonitride, and a carbide may be provided between the base material of the tool and the hard coating film. In addition, a hard coating film having a component ratio or a composition different from that of the hard coating film according to the present embodiment may be formed separately on the hard coating film according to the present embodiment. Moreover, the hard coating film according to the present embodiment and a hard coating film having a composition ratio or a composition different from that of the hard coating film according to the present embodiment may be laminated separately on one another.

The hard coating film according to the present embodiment is preferable because it is provided as the outermost layer of a tool which comes into contact with a workpiece, such that a sufficient amount of a protective oxide coating film is formed on the tool surface such that an effect of curbing adhesion is exhibited sufficiently.

When the hard coating film according to the present embodiment is coated, a sputtering method is applied. In the method, three or more AlTi-based alloy targets are used, and power is applied sequentially to the targets. When the target for applying power is switched, there is a time during which power is applied simultaneously to both targets including a target where application of power ends and a target where application of power starts. In such a sputtering method, a state of a high ionization rate of a target is maintained during coating, a dense hard coating film having granules at a micro-level can be obtained, and there tends to be less argon, oxygen, and carbon which are unavoidably contained. Furthermore, it is preferable that pre-discharging be performed while the internal temperature of a furnace of a sputtering device is set to 450°C or higher, the flow rate of nitrogen gas introduced into the furnace is set to 60 sccm or greater, and the flow rate of argon gas is set in a range of 70 sccm to 200 sccm. In addition, it is preferable that the internal pressure of the furnace be set in a range of 0.5 Pa to 0.7 Pa.

It is preferable that the maximum power density of a power pulse be set to 1.0 kW/cm² or higher. It is more preferably set to 1.2 kW/cm² or higher. However, if the power density applied to a target becomes excessively high, film formation is unlikely to be stable. In addition, if the power density is excessively high, the generation frequency of droplets tends to increase even in the sputtering method. Therefore, it is preferable that the maximum power density of the power pulse be set to 3.0 kW/cm² or lower. It is more preferable that the maximum power density of the power pulse be set to 2.0 kW/cm² or lower. In addition, it is preferable that the time during which power is applied simultaneously to both alloy targets including an alloy target where applying of power ends and an alloy target where applying of power starts be set in a range of 5 microseconds to 20 microseconds to reduce droplets and enhance basic characteristics of the hard coating film. In addition, it is preferable that a negative bias voltage applied to the base material be set in a range of -80 V to -40 V

### [Example 1]

### <Tool>

As a tool, an ultra-hard alloy two-blade ball end mill (ball radius 3 mm, manufactured by Mitsubishi Hitachi Tool Engineering Ltd.) having a composition of WC (bal.)-Co (8.0 mass%)-Cr (0.5 mass%)-VC (0.3 mass%), a WC average grain size of 0.6 µm, and a hardness of 93.9 HRA (Rockwell hardness, a value measured based on JIS G 0202) was prepared.

In the present Examples 1 to 3 and Comparative Example 1, a sputtering device in which six sputter vaporization sources can be mounted was used. Three AlTi-based alloy targets of these vapor deposition sources were installed inside the device as the vapor deposition sources. Targets having a dimension of φ 16 cm and a thickness of 12 mm were used. The compositions of the AlTi-based alloy targets used in the present Examples 1 to 3 were the same as each other.

The tool was fixed to a sample holder inside the sputtering device, and a bias power supply was connected to the tool. The bias power supply had a structure for applying a negative bias voltage to the tool independent from the target. The tool revolved twice every minute and rotated via a fixing jig and the sample holder. The distance between the tool and the target surface was set to 100 mm.

Ar and N₂ were used as introduction gases and were introduced through a gas supply port provided in the sputtering device.

### <Bombardment treatment>

First, before the tool was coated with a hard coating film, the tool was subjected to bombardment treatment by the following procedure. In a state where the internal temperature of the furnace became 430°C due to a heater inside the sputtering device, heating was performed for 30 minutes. Thereafter, the inside of the furnace of the sputtering device was evacuated to set the internal pressure of the furnace to 5.0×10⁻³ Pa or lower. Then, Ar gas was introduced into the furnace of the sputtering device, and the internal pressure of the furnace was adjusted to 0.8 Pa. Furthermore, a DC bias voltage of -170 V was applied to the tool, and cleaning (bombardment treatment) of the tool was performed by Ar ions.

### <Coating of hard coating film>

Subsequently, the tool was coated with a nitride of Al and Ti by the following procedure.

In the present Example 1 and Comparative Example 1, while the internal temperature of the furnace was maintained at 430°C, Ar gas was introduced into the furnace of the sputtering device at 160 sccm, N₂ gas was introduced at 120 sccm thereafter, and the internal pressure of the furnace was set to 0.60 Pa. A DC bias voltage of -60 V was applied to the tool. Furthermore, a discharge time per cycle of power applied to the alloy targets containing Al and Ti was set to 4.0 milliseconds. When the alloy target for applying power was switched, the time during which power was applied simultaneously to the two alloy targets including an alloy target where applying of power ended and an alloy target where applying of power started was set to 10 microseconds. Power was applied continuously to the three AlTi-based alloy targets, and the surface of the tool was coated with a hard coating film of approximately 3.0 µm. At this time, the maximum power density of the power pulse was set to 1.5 kW/cm², and the average power density was set to 0.37 kW/cm².

In the present Example 2, the tool was coated with a hard coating film under conditions similar to those of the present Example 1, except that Ar gas was introduced at 160 sccm, N₂ gas was introduced at 160 sccm thereafter, and the internal pressure of the furnace was set to 0.68 Pa.

In the present Example 3, the tool was coated with a hard coating film under conditions similar to those of the present Example 1, except that Ar gas was introduced at 160 sccm, N₂ gas was introduced at 160 sccm thereafter, the internal pressure of the furnace was set to 0.68 Pa, and a DC bias voltage of -80 V was applied to the tool.

In Comparative Examples 2 to 6, samples coated by an arc ion plating method were prepared.

In Comparative Examples 2 and 3, coating was performed by an arc ion plating device in which a permanent magnet was disposed on the rear surface of the target. In addition, in Comparative Examples 4 to 6, coating was performed by an arc ion plating device in which a coil magnet was disposed on the rear surface of the target. In all of the samples, the tool was cleaned using Ar ions, the furnace was evacuated to an internal pressure of 5.0×10⁻³ Pa or lower, the internal temperature of the furnace was set to 500°C, and N₂ gas was introduced such that the internal pressure of the furnace became 3.2 Pa. A DC bias voltage of -120 V was applied to the tool. Furthermore, a current of 200 A was applied to the alloy targets containing Al and Ti, and the surface of the tool was coated with a hard coating film of approximately 3.0 µm.

### <Coating film composition>

Regarding the coating film composition of the hard coating film, the coating film composition of the hard coating film was measured using an attached wavelength dispersive X-ray spectroscopy electron probe micro-analyzer (WDS-EPMA) using an electron probe microanalyzer (JXA-8500F manufactured by JEOL Ltd.). A ball end mill for physical property evaluation was subjected to specular working, the accelerating voltage was set to 10 kV, the irradiation current was set to 5×10⁻⁸ A, the fetching time was set to 10 seconds, and five points of a range of which the analysis region had a diameter of 1 µm were measured, thereby obtaining the amount of a metal and the amount of Ar in the total amount of the metal component and the non-metal component in the hard coating film from the average value thereof.

### <Crystal structure and crystal grain size>

The crystal structure of the hard coating film was confirmed using an X-ray diffractometer (EMPYREAN manufactured by PANalytical Ltd.) under measurement conditions of a tube voltage of 45 kV, a tube current of 40 mA, a Cukα X-ray source (λ=0.15405 nm), and 20 within a range of 20 to 80 degrees. In addition, the average crystal grain size of the hard coating film was calculated from the half width of the diffraction peak indicating the maximum intensity.

### <Coating film hardness and elastic coefficient>

The coating film hardness and the elastic coefficient of the hard coating film were analyzed using a nanoindentation tester (ENT-2100 manufactured by ELIONIX INC.). In the analysis, a cross section of a coating film in which a test piece was tilted five degrees with respect to the outermost surface of the coating film was subjected to mirror polishing. Thereafter, a region in which the maximum thrust depth became substantially less than 1/10 of the film thickness inside the polished surface of the coating film was selected. Measurement was performed at ten points under a measurement condition of a thrust load of 49 mN/second, and the average value of six points, excluding the two points with largest and the two points with the smallest values, was obtained.

### <Cutting test>

A cutting test was performed using the produced coated cutting tool. Table 1 shows the analysis results and the cutting test results. The cutting conditions were as follows.

### (Condition) dry working

* Tool: ultra-hard two-blade ball end mill
* Type number: HGOB2060, ball radius 3.0 mm
* Cutting method: bottom-surface cutting
* Workpiece: STAVAX (52 HRC) (manufactured by Bohler Uddeholm Corp.)
* Cut: 0.2 mm in the axial direction, and 0.2 mm in the radial direction
* Cutting speed: 188.4 m/min
* Feeding rate per blade: 0.2 mm/blade
* Cutting distance: 500 m
* Evaluation method: after cutting working, observation was performed using a tool microscope at a magnification of 50 times, and the abraded region between the tool and the workpiece was measured. A part having the largest abrasion region was set as the largest wear area.

In each of the samples, the coating film characteristics and the coating film structure were observed. Table 1 shows the results of the coating film characteristics and the cutting evaluation.

**[Table 1]**

| Sample No. | Coating film composition (at%) | Ar content (at%) | Crystal structure indicating maximum intensity | Average crystal grain size (nm) | Nanoindentation hardness (GPa) | Elastic coefficient (GPa) | Largest wear area (µm) |
|---|---|---|---|---|---|---|---|
| Present Example 1 | (Al83Ti17)N | 0.19 | hcp (100) | 8 | 24 | 300 | 51 |
| Present Example 2 | (Al81Ti19)N | 0.22 | hcp (100) | 9 | 27 | 330 | 45 |
| Present Example 3 | (Al81Ti19)N | 0.24 | hcp (100) | 8 | 25 | 310 | 47 |
| Comparative Example 1 | (Al91Ti9)N | 0.17 | hcp (102) | 9 | 24 | 320 | peeled off |
| Comparative Example 2 | (Al71Ti29)N | 0 | fcc (200) | 8 | 32 | 440 | 69 |
| Comparative Example 3 | (A177Ti23)N | 0 | hcp (100) | 6 | 25 | 310 | 66 |
| Comparative Example 4 | (Al69Ti31)N | 0 | fcc (200) | 7 | 28 | 350 | 72 |
| Comparative Example 5 | (Al79Ti21)N | 0 | hcp (100) | 7 | 27 | 320 | peeled off |
| Comparative Example 6 | (Al91Ti9)N | 0 | hcp (100) | 7 | 27 | 370 | peeled off |

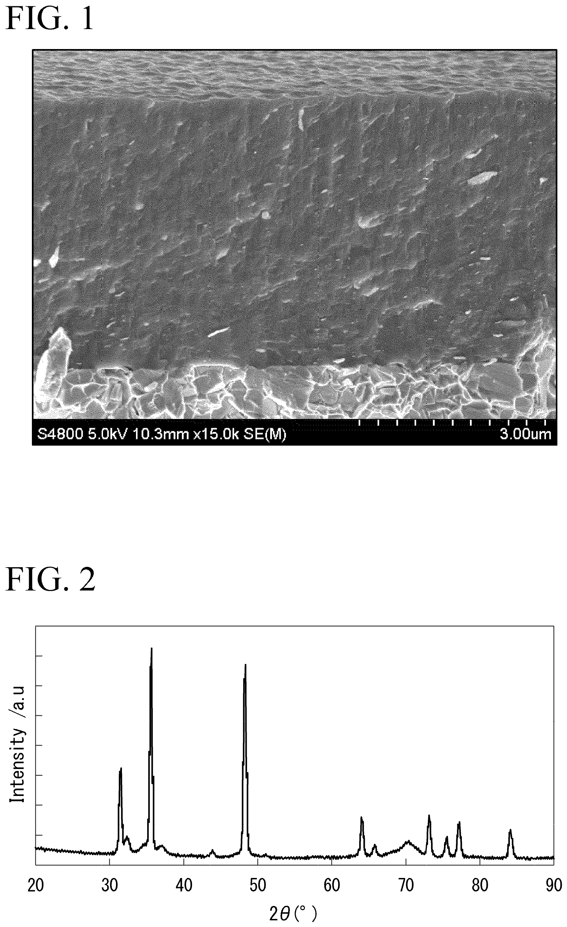

As an example of the X-ray diffraction results of the present Example, Fig. 2 shows the X-ray diffraction results of the present Example 2. As shown in Fig. 2 as an example, in all of the present Examples 1 to 3, a peak due to the fcc structure was not confirmed, and the peak due to the AlN (100) plane having an hcp structure was the largest.

In the present Examples 1 to 3, sudden peeling off did not occur, and it was confirmed that the largest wear area was smaller and excellent durability was exhibited compared to Comparative Examples 2 to 6 coated by the arc ion plating method. In particular, Comparative Example 2 was a nitride of Al and Ti in the related art having an fcc structure. However, in the present Examples 1 to 3, the largest wear area was reduced by 10 µm or larger with respect to Comparative Example 2. As a reason therefor, it was assumed that durability was enhanced even if the hard coating film had an hcp structure and an effect of a significant amount of Al was exhibited because there were less defects of droplets included inside the coating film, argon, or the like in the present Examples 1 to 3. In the present Examples 2 and 3 in which particularly excellent durability was reproduced, when the amount of the metallic (including metalloid) elements, nitrogen, oxygen, carbon, and argon was 100 at%, the amount of nitrogen was 50 at% or greater, and therefore it was assumed that excellent durability could be obtained because a nitride was formed sufficiently in the hard coating film.

Fig. 1 shows a cross-sectional observation photograph of the present Example 1. It was confirmed that the hard coating film according to the present Example 1 was extremely smooth. In addition, in the hard coating film according to the present Example 1, it was confirmed that there was one or fewer droplets having an equivalent circle diameter of 1.0 µm or larger per 100 µm² through the cross-sectional observation. No droplet having an equivalent circle diameter of 3.0 µm or larger was confirmed. On the other hand, in the hard coating films of Comparative Examples 2 to 6 coated by the arc ion plating method, tens of droplets having an equivalent circle diameter of 1.0 µm or larger per 100 µm² were confirmed. In addition, a number of droplets having an equivalent circle diameter of 3.0 µm or larger were also confirmed. Particularly, in Comparative Example 6, although the diffraction peak of the hcp (100) plane indicated the maximum intensity similar to the present Example 1, peeling off occurred. As a reason therefor, it was assumed that the toughness deteriorated due to many droplets and peeling off occurred in an early stage.

In Comparative Example 1, similar to the present Example, it was assumed that although there were less defects of droplets, argon, or the like, a (102) plane having an hcp structure indicated the maximum intensity so that the toughness deteriorated and peeling off occurred in an early stage.

The hard coating film according to the present Example was subjected to microanalysis. In the hard coating film according to the present Example, it was confirmed that oxygen was within a range of 1.5 to 3.0 at% and carbon was 1.0 at% or less from a position at a depth of 50 nm in the film thickness direction from the coating film surface, that is, slight amounts of oxygen and carbon were contained, through the analysis using a scanning X-ray photoelectron spectroscope device.

In addition, when the structure was observed using a transmission electron microscope, it was confirmed that there was one or fewer voids of which the longest diameter was 10 nm or larger within an area of 50 nm×50 nm while they were dense at a micro-level.

### [Example 2]

In Example 2, evaluation was performed by changing the tool and the workpiece with respect to the present Examples 1 to 3 and Comparative Example 1 evaluated in Example 1.

In Example 2, as a tool, an ultra-hard alloy two-blade ball end mill (ball radius 3 mm, manufactured by Mitsubishi Hitachi Tool Engineering Ltd.) having a composition of WC (bal.)-Co (8.0 mass%)-Cr (0.5 mass%)-VC (0.3 mass%), a WC average grain size of 0.6 µm, a hardness of 93.9 HRA (Rockwell hardness, a value measured based on JIS G 0202) was prepared.

The cutting conditions were as follows.

### (Condition) dry working

* Tool: ultra-hard two-blade ball end mill
* Type number: HGOB2060, ball radius 3.0 mm
* Cutting method: bottom-surface cutting
* Workpiece: DAC55 (47HRC) (manufactured by Hitachi Metals Ltd.)
* Cut: 0.2 mm in the axial direction, and 0.2 mm in the radial direction
* Cutting speed: 188.4 m/min
* Feeding rate per blade: 0.2 mm/blade
* Cutting distance: 150 m
* Evaluation method: after cutting working, observation was performed using a tool microscope at a magnification of 50 times, and the abraded region between the tool and the workpiece was measured. A part having the largest abrasion region was set as the largest wear area.

In each of the samples, the coating film characteristics and the coating film structure were observed. Table 2 shows the results of the cutting evaluation.

**[Table 2]**

| Sample No. | Largest wear area (µm) |
|---|---|
| Present Example 1 | 143 |
| Present Example 2 | 85 |
| Present Example 3 | 75 |
| Comparative Example 1 | peeled off |

In Example 2 as well, the present Examples 1 to 3 exhibited a stable wear form. On the other hand, in Comparative Example 1 in which the (102) plane having an hcp structure indicated the maximum intensity, peeling off occurred in an early stage. Particularly, in the present Examples 2 and 3 of the present Examples 1 to 3, when the amount of the metallic (including metalloid) elements, nitrogen, oxygen, carbon, and argon was 100 at%, the amount of nitrogen was 50 at% or greater, and the largest wear area was reduced significantly compared to the present Example 1.

## Claims

1. A coated cutting tool comprising:
a hard coating film on a surface of the tool,
wherein the hard coating film is a nitride containing aluminum (Al) within a range of 80 at% to 90 at% and containing titanium (Ti) within a range of 10 at% to 20 at% with respect to a total amount of metallic including metalloid elements, and containing argon (Ar) of 0.10 at% or more and_0.50 at% or less with respect to a total amount of the metallic including metalloid elements and nonmetallic elements,
wherein in the hard coating film, a crystal structure identified through X-ray diffraction is a single phase with a hexagonal closest packing structure and a diffraction peak due to an AlN (100) plane indicates a maximum intensity,
wherein an average crystal grain size is within a range of 5 nm to 50 nm, and
wherein in a cross-sectional observation of the hard coating film, there are five or fewer droplets having an equivalent circle diameter of 1.0 µm or larger per 100 µm^{2,}
wherein the amount of metallic elements is measured using a electron probe microanalyzer according to the method in the description and the crystal structure, the diffraction peak indicating a maximum intensity, the average crystal grain size and the number of droplets are determined in accordance with the specifics given in the description.

2. The coated cutting tool according to claim 1,
wherein in the hard coating film, when an amount of the metallic including metalloid elements, nitrogen, oxygen, carbon, and argon is 100 at%, an amount of the nitrogen is 50 at% or greater.

3. The coated cutting tool according to claim 1 or 2,
wherein the hard coating film is provided in an outermost layer of the tool which comes into contact with a workpiece.

## Patentansprüche

1. Beschichtetes Schneidwerkzeug, umfassend:
einen harten Beschichtungsfilm auf einer Oberfläche des Werkzeugs,
wobei der harte Beschichtungsfilm ein Nitrid ist, das Aluminium (Al) innerhalb eines Bereichs von 80 Atom-% bis 90 Atom-% enthält und Titan (Ti) innerhalb eines Bereichs von 10 Atom-% bis 20 Atom-% enthält, in Bezug auf eine Gesamtmenge an metallischen, einschließlich metalloiden Elementen, und das Argon (Ar) von 0,10 Atom-% oder mehr und 0,50 Atom-% oder weniger enthält, in Bezug auf eine Gesamtmenge an metallischen, einschließlich metalloiden Elementen und nichtmetallischen Elementen,
wobei in dem harten Beschichtungsfilm eine durch Röntgenbeugung identifizierte Kristallstruktur eine einzige Phase mit einer hexagonal dichtesten Packungsstruktur ist und ein Beugungspeak aufgrund einer AIN (100)-Ebene eine maximale Intensität anzeigt,
wobei eine durchschnittliche Kristallkorngröße innerhalb eines Bereichs von 5 nm bis 50 nm liegt, und
wobei in einer Querschnittsbetrachtung des harten Beschichtungsfilms fünf oder weniger Tröpfchen, die einen äquivalenten Kreisdurchmesser von 1,0 µm oder größer pro 100 µm^{2,} aufweisen, vorhanden sind,
wobei die Menge an metallischen Elementen unter Verwendung eines Elektronensonden-Mikroanalyzers gemäß dem Verfahren in der Beschreibung gemessen wird und
die Kristallstruktur, der Beugungspeak, der eine maximale Intensität anzeigt, die durchschnittliche Kristallkorngröße und die Anzahl der Tröpfchen in Übereinstimmung mit den in der Beschreibung angegebenen Angaben bestimmt werden.

2. Beschichtetes Schneidwerkzeug nach Anspruch 1,
wobei in dem harten Beschichtungsfilm, wenn eine Menge an metallischen, einschließlich metalloiden Elementen, Stickstoff, Sauerstoff, Kohlenstoff und Argon 100 Atom-% ist, eine Menge des Stickstoffs 50 Atom-% oder mehr ist.

3. Beschichtetes Schneidwerkzeug nach Anspruch 1 oder 2,
wobei der harte Beschichtungsfilm in einer äußersten Schicht des Werkzeugs bereitgestellt wird, die in Kontakt mit einem Werkstück kommt.

## Revendications

1. Outil de coupe revêtu, comprenant :
un film de revêtement dur sur une surface de l'outil,
dans lequel le film de revêtement dur est un nitrure contenant de l'aluminium (Al) dans une plage de 80 % at à 90 % at et contenant du titane (Ti) dans une plage de 10 % at à 20 % at par rapport à une quantité totale d'éléments métalliques incluant des métalloïdes, et contenant de l'argon (Ar) à 0,10 % at ou plus et à 0,50 % at ou moins par rapport à une quantité totale d'éléments métalliques incluant des métalloïdes et d'éléments non-métalliques,
dans lequel dans le film de revêtement dur, une structure cristalline identifiée par diffraction des rayons X est une phase unique dotée d'une structure d'empilement la plus compacte hexagonale et un pic de diffraction en raison d'un plan AIN (100) indique une intensité maximale,
dans lequel une taille moyenne de grain cristallin est dans une plage de 5 nm à 50 nm, et
dans lequel dans une observation en coupe transversale du film de revêtement dur, il existe cinq gouttelettes ou moins présentant un diamètre de cercle équivalent de 1,0 µm ou plus par 100 µm²,
dans lequel la quantité d'éléments métalliques est mesurée à l'aide d'un microanalyseur de sonde électronique conformément au procédé selon la description et
la structure cristalline, le pic de diffraction indiquant une intensité maximale, la taille moyenne de grain cristallin et le nombre de gouttelettes sont déterminés conformément aux spécificités données dans la description.

2. Outil de coupe revêtu selon la revendication 1,
dans lequel dans le film de revêtement dur, lorsqu'une quantité d'éléments métalliques incluant des métalloïdes, d'azote, d'oxygène, de carbone et d'argon, représente 100 % at, une quantité d'azote est de 50 % at ou plus.

3. Outil de coupe revêtu selon la revendication 1 ou la revendication 2,
dans lequel le film de revêtement dur est disposé dans une couche la plus extérieure de l'outil qui vient en contact avec une pièce.
